# FASCICULE DE BREVET EUROPEEN

(11) **EP 0 865 671 B1**
(45) Date de publication et mention de la délivrance du brevet: **11.09.2002**
(21) Numéro de dépôt: 97943937.9
(22) Date de dépôt: 03.10.1997
(51) Int. Cl.: H01L 29/745, H01L 29/749, H01L 29/74

(54) **THYRISTOR DUAL NORMALEMENT PASSANT**
NORMAL LEITENDER DUAL-THYRISTOR
NORMALLY CONDUCTING DUAL THYRISTOR

(30) Priorité: 04.10.1996 FR 9612323
(43) Date de publication de la demande: 23.09.1998
(73) Titulaire: CENTRE NATIONAL DE LA RECHERCHE SCIENTIFIQUE (CNRS), 75700 Paris Cedex 07 (FR)
(72) Inventeur: SANCHEZ, Jean-Louis, F-31750 Escalquens (FR); JALADE, Jean, F-31320 Castanet-Tolosan (FR); LAUR, Jean-Pierre, F-81000 Albi (FR); FOCH, Henri, F-31200 Toulouse (FR)
(74) Mandataire: de Beaumont, Michel
(86) Numéro de dépôt international: FR9701756
(87) Numéro de publication internationale: WO98015982

(56) Documents cités:
- DE-A- 2 625 917
- FR-A- 2 524 711
- US-A- 4 546 401
- SANCHEZ J -L ET AL: "NEW HIGH VOLTAGESWITCHES: SPONTANEOUSLY FIRED MOS-THYRISTOR DEVICES" EPE '95: 6TH. EUROPEAN CONFERENCE ON POWER ELECTRONICS AND APPLICATIONS, SEVILLA, SEPT. 19 - 21, 1995, vol. 1, 19 septembre 1995, EUROPEAN POWER ELECTRONICS AND DRIVES ASSOCIATION, pages 1.637-1.642, XP000537596

## Description

La présente invention concerne un thyristor dual, c'est-à-dire un composant dont les caractéristiques se déduisent de celles d'un thyristor classique en appliquant les règles de dualité aux comportements en courant et en tension et aux modes de commande.

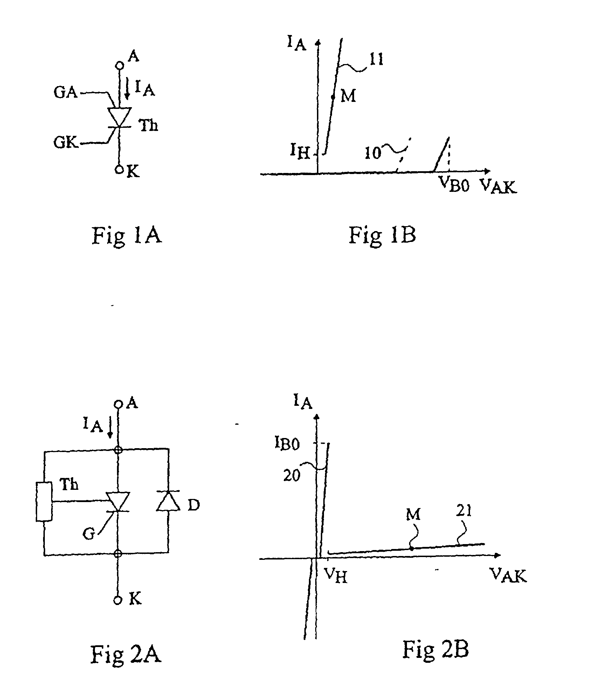

La figure 1A représente un thyristor classique Th comportant une anode A, une cathode K, et des gâchettes de cathode GK et d'anode GA.

La courbe caractéristique d'un thyristor est illustrée en figure 1B. Ce composant présente les caractéristiques suivantes :
- il est normalement bloqué,
- il est unidirectionnel en courant, c'est-à-dire qu'il est susceptible de laisser passer un courant I_{A} positif mais bloque un courant négatif,
- il est bidirectionnel en tension, c'est-à-dire qu'il est susceptible de supporter à l'état bloqué des tensions positives ou négatives,
- il est amorçable par une impulsion de courant appliquée sur sa gâchette quand la tension à ses bornes est positive ; ceci est illustré en figure 1B par la courbe 10, c'est-à-dire que, quand un courant de gâchette lui est appliqué, il devient passant par retournement, et sa caractéristique devient celle indiquée par la courbe 11,
- il est auto-amorçable quand la tension à ses bornes dépasse une valeur VBO en l'absence de courant de gâchette,
- il présente un blocage spontané quand le courant qui le traverse devient faible (inférieur à une valeur de courant de maintien I_{H}).

Le symbole d'un thyristor dual est illustré en figure 2A. Ce thyristor dual présente des caractéristiques tension-courant duales de celles d'un thyristor classique, comme cela est représenté en figure 2B :
- il est normalement passant,
- il est bidirectionnel en courant, c'est-à-dire qu'il est susceptible de laisser passer aussi bien un courant positif qu'un courant négatif (le passage d'un courant négatif est assuré par la diode D illustrée en figure 2A),
- il est unidirectionnel en tension, c'est-à-dire qu'il est susceptible de supporter à l'état bloqué uniquement des tensions positives, du fait de la présence de la diode D,
- il est bloquable par une impulsion de tension appliquée sur la gâchette, c'est-à-dire que, si, alors que le point de fonctionnement est sur la courbe 20, une tension de commande est appliquée, la caractéristique de fonctionnement deviendra celle désignée par la référence 21,
- il présente une caractéristique d'auto-blocage, c'est-à-dire que, si le courant qui le traverse dépasse une valeur I_{BO}, il se bloque de lui-même,
- il présente un amorçage spontané au passage au zéro de tension, c'est-à-dire que, si, alors qu'il est à l'état bloqué, la tension à ses bornes chute en dessous d'une tension de seuil V_{H}, il redevient conducteur.

En d'autres termes, alors qu'un thyristor constitue un interrupteur unidirectionnel en courant normalement bloqué amorçable par un courant de commande ou auto-amorçable au-delà d'un certain seuil de tension, un thyristor dual constitue un interrupteur normalement passant bloquable par une tension de commande ou auto-bloquable au-delà d'un certain seuil de tension.

Dans l'art antérieur, la réalisation d'un système ayant la fonction d'un thyristor dual a été effectuée en associant à un composant interrupteur un circuit de commande spécifique. Cette solution présente deux inconvénients. Le premier est qu'il est toujours difficile d'associer de façon monolithique des circuits de commande et un composant de puissance. Le deuxième est qu'il est nécessaire de prévoir pour le circuit de commande une alimentation auxiliaire volumineuse, coûteuse et éventuellement sensible aux perturbations environnantes. Un thyristor dual simplifié non commandable par impulsions est décrit dans EPE'95 : 6TH European Conferance on Power Electronics and Applications, Séville, 19-21 sept. 1995, vol. 1, 19 sept. 1995, P. 1.637 à 1.642, X P 000537596, J-L Sanchez et al.

Ainsi, un objet de la présente invention est de prévoir un assemblage simple de composants ayant la fonction d'un thyristor dual.

Un autre objet de la présente invention est de prévoir un tel assemblage sous forme de composant monolithique.

Un autre objet de la présente invention est de prévoir un tel composant monolithique fabriquable par des technologies usuelles.

Pour atteindre ces objets ainsi que d'autres, la présente invention prévoit un composant constituant un thyristor dual, normalement passant et bloquable par une impulsion de tension sur l'électrode de commande, comprenant un thyristor, un moyen résistif constitué d'un premier transistor MOS à déplétion dont la grille est reliée à la source, le substrat de ce transistor étant relié à la borne de gâchette de cathode, connecté entre la gâchette d'anode et la cathode du thyristor, et un moyen interrupteur à conduction commandée constitué d'un deuxième transistor MOS à enrichissement dont la grille est connectée à une borne de commande et dont le substrat est connecté à la borne de gâchette de cathode, connecté entre la gâchette de cathode et la cathode du thyristor.

Selon un mode de réalisation de la présente invention, le composant est à commande par impulsion et comprend en outre des moyens de maintien de la conduction entre la gâchette de cathode et la cathode dès que cette conduction a été amorcée par le moyen interrupteur.

Selon un mode de réalisation de la présente invention, les moyens de maintien comprennent un troisième transistor MOS à enrichissement, dont le substrat est connecté à la borne de gâchette de cathode, en parallèle sur le deuxième transistor MOS à enrichissement ; une diode Zener connectée entre la cathode du thyristor et un noeud lié à la grille du troisième transistor ; et un quatrième transistor MOS à déplétion connecté entre ledit noeud et la gâchette d'anode du thyristor, la grille du quatrième transistor étant connectée à la cathode et son substrat audit noeud.

Selon un mode de réalisation de la présente invention, on réalise un composant à faible courant de fuite en prévoyant, en série avec le premier transistor MOS à déplétion, un deuxième moyen interrupteur, normalement passant et bloqué après qu'un ordre de commande a été appliqué au deuxième transistor.

Selon un mode de réalisation de la présente invention, le deuxième moyen interrupteur est un transistor MOS à déplétion à canal P et à substrat flottant dont la grille est connectée audit noeud.

Selon un mode de réalisation de la présente invention, le thyristor est réalisé sous forme verticale dans un substrat de silicium d'un premier type de conductivité ; le premier transistor MOS à déplétion est réalisé entre la région de cathode du thyristor et le substrat ; chacun des deuxième et troisième transistors MOS à enrichissement est formé entre deux régions du premier type de conductivité formées dans un premier caisson de gâchette de cathode du thyristor, l'une de ces deux régions correspondant à la région de cathode du thyristor ; le quatrième transistor MOS à déplétion est formé entre une région du premier type de conductivité, elle-même formée dans un deuxième caisson du deuxième type de conductivité disjoint du caisson de gâchette du thyristor, et le substrat ; et la diode Zener est formée dans ledit deuxième caisson.

Selon un mode de réalisation de la présente invention, le composant est formé à partir d'un substrat du premier type de conductivité dont la face arrière est revêtue d'une couche du deuxième type de conductivité revêtue d'une première métallisation et comprend du côté de sa face avant un premier caisson du deuxième type de conductivité contenant des première, deuxième, troisième et quatrième régions du premier type de conductivité, les première et deuxième régions étant séparées par une portion du premier caisson revêtue d'une première métallisation de grille isolée, les troisième et quatrième régions étant séparées par une portion du premier caisson revêtue d'une deuxième métallisation de grille isolée, une portion au moins du premier caisson séparant la première et/ou la quatrième région du substrat comportant en face supérieure une première région de canal préformé revêtue d'une troisième métallisation de grille isolée, une deuxième métallisation revêtant la première région, une troisième métallisation revêtant les deuxième et troisième régions et une portion de la surface supérieure du premier caisson, une quatrième métallisation revêtant la quatrième région ; et un deuxième caisson du deuxième type de conductivité comprenant des cinquième et sixième régions du premier type de conductivité, la cinquième région étant séparée du substrat par une deuxième région de canal préformé revêtue d'une quatrième métallisation de grille isolée, la sixième région formant avec le deuxième caisson une jonction Zener, une cinquième métallisation revêtant les cinquième et sixième régions et les reliant au deuxième caisson, une sixième métallisation étant en contact avec une portion du deuxième caisson voisine de la sixième région. La deuxième métallisation de grille isolée est destinée à être connectée à une borne de commande ; les deuxième, quatrième et sixième métallisations ainsi que les troisième et quatrième métallisations de grille isolée sont destinées à être connectées à une borne de cathode, la cinquième métallisation étant reliée à la première métallisation de grille isolée.

Selon un mode de réalisation de la présente invention, le thyristor est réalisé sous forme verticale dans un substrat de silicium d'un premier type de conductivité ; le premier transistor MOS à déplétion est formé dans un troisième caisson disjoint du premier caisson de gâchette de cathode du thyristor, entre une région formée dans ce troisième caisson et le substrat ; chacun des deuxième et troisième transistors MOS à enrichissement est formé entre une région du premier type de conductivité, formée dans le caisson de gâchette de cathode du thyristor, et la région de cathode du thyristor ; le quatrième transistor MOS à déplétion est formé entre une région du premier type de conductivité, elle-même formée dans un deuxième caisson du deuxième type de conductivité disjoint du caisson de gâchette du thyristor, et le substrat ; la diode Zener est formée dans ledit deuxième caisson ; et le cinquième transistor MOS à canal P à déplétion est formé entre le deuxième caisson et une région supplémentaire du deuxième type de conductivité.

Selon un mode de réalisation de la présente invention, le composant est formé à partir d'un substrat du premier type de conductivité dont la face arrière est revêtue d'une couche du deuxième type de conductivité revêtue d'une première métallisation et comprend, du côté de sa face avant, un premier caisson du deuxième type de conductivité contenant des première, deuxième et troisième régions du premier type de conductivité, les première et deuxième régions étant séparées par une portion du premier caisson revêtue d'une première métallisation de grille isolée, les première et troisième régions étant séparées par une portion du premier caisson revêtue d'une deuxième métallisation de grille isolée, la première région étant revêtue d'une deuxième métallisation, la deuxième région étant revêtue d'une troisième métallisation s'étendant sur une portion du premier caisson, la troisième région étant revêtue d'une quatrième métallisation s'étendant sur une portion du premier caisson ; un deuxième caisson du deuxième type de conductivité comprenant des quatrième et cinquième régions du premier type de conductivité, la quatrième région étant séparée du substrat par une première région de canal préformé revêtue d'une troisième métallisation de grille isolée, la cinquième région formant avec le deuxième caisson une jonction Zener, une cinquième métallisation revêtant les quatrième et cinquième régions et les reliant au deuxième caisson, une sixième métallisation étant en contact avec une portion du deuxième caisson voisine de la cinquième région ; et un troisième caisson du deuxième type de conductivité contenant une sixième région du premier type de conductivité, une portion au moins du caisson séparant la sixième région du substrat comportant en face supérieure une deuxième région de canal préformé revêtue d'une quatrième métallisation de grille isolée, le troisième caisson étant séparé d'une région du deuxième type de conductivité par une région du deuxième type de conductivité faiblement dopée revêtue d'une cinquième métallisation de grille isolée, la sixième région et une partie de la surface supérieure du troisième caisson étant revêtues d'une septième métallisation, la surface supérieure de ladite région du deuxième type de conductivité faiblement dopée étant revêtue d'une huitième métallisation. La première métallisation de grille isolée est destinée à être connectée à une borne de commande ; les deuxième, sixième et huitième métallisations ainsi que les troisième et quatrième métallisations de grille isolée sont destinées à être connectées à une borne de cathode, la cinquième métallisation étant reliée aux deuxième et cinquième métallisations de grille isolée.

Selon un mode de réalisation de la présente invention, chacun des caissons comprend des zones plus fortement dopées au moins aux emplacements où une métallisation est en contact avec une portion de leur surface supérieure.

Ces objets, caractéristiques et avantages, ainsi que d'autres de la présente invention seront exposés en détail dans la description suivante de modes de réalisation particuliers faite, à titre non-limitatif, en relation avec les figures jointes parmi lesquelles :
les figures 1A et 1B représentent un thyristor et sa courbe caractéristique courant-tension ;
les figures 2A et 2B représentent un thyristor dual et sa courbe caractéristique courant-tension ;
les figures 3A et 3B représentent un premier exemple de circuit constituant un thyristor dual selon l'invention ;
la figure 4 représente un deuxième exemple de circuit constituant un thyristor dual selon l'invention ;
la figure 5 représente un troisième exemple de circuit constituant un thyristor dual selon l'invention ;
la figure 6 représente une vue en coupe schématique d'un composant semiconducteur mettant en oeuvre les fonctions du circuit de la figure 4 ; et
la figure 7 représente une vue en coupe schématique d'un composant semiconducteur mettant en oeuvre les fonctions du circuit de la figure 5.

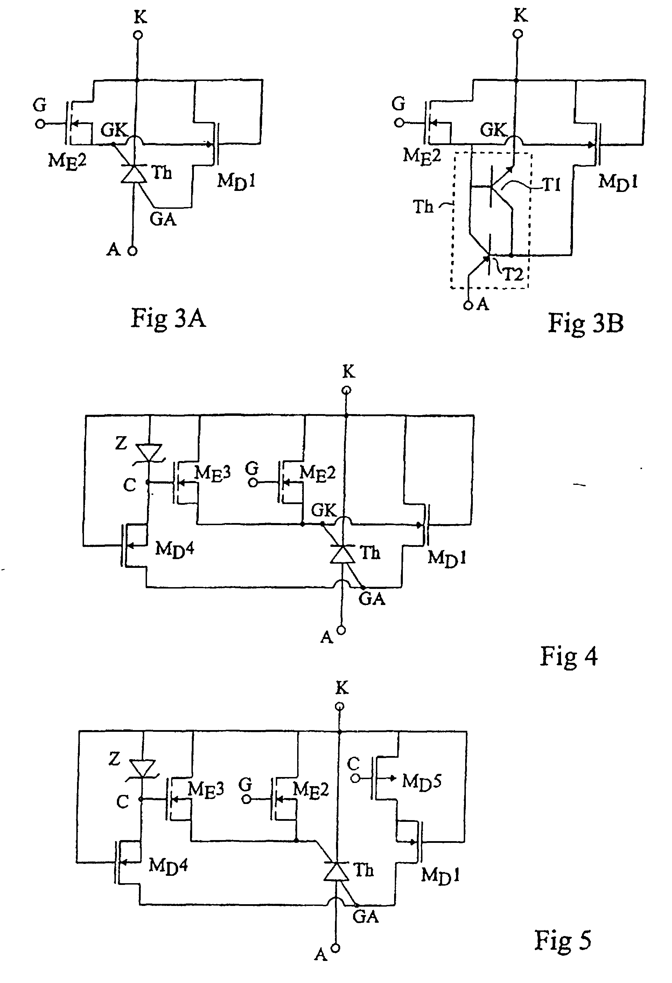

La figure 3A représente un premier mode de réalisation d'un thyristor dual selon la présente invention. Ce thyristor dual est construit à partir d'un thyristor Th ayant une borne d'anode A, une borne de cathode K, une borne de gâchette de cathode GK et une borne de gâchette d'anode GA. La borne GA est reliée à la borne K par l'intermédiaire d'un transistor MOS à canal N à déplétion M_{D}1. La grille du transistor M_{D}1 est également reliée à la borne K. La borne GK est reliée à la borne K par l'intermédiaire d'un transistor MOS à canal N à enrichissement M_{E}2. Le drain du transistor M_{E}2, relié à la borne GK, est également relié au substrat de ce transistor M_{E}2. La grille du transistor M_{E}2 est reliée à une borne de commande G. Les substrats des transistors M_{D}1 et M_{E}2 sont reliés à la borne GK.

Le fonctionnement de ce circuit est le suivant. Dès que la tension anode-cathode V_{AK} croît dans le sens positif, un courant de gâchette d'anode circule de la borne A à la borne K par la gâchette d'anode GA et le transistor M_{D}1 qui est normalement passant. En conséquence, le thyristor Th devient passant et agit comme un interrupteur fermé.

Pour ouvrir le thyristor Th, il convient d'appliquer sur la borne de grille G du transistor M_{E}2 une tension positive par rapport à la cathode. Le transistor M_{E}2 court-circuite alors la cathode et la gâchette de cathode du thyristor et le bloque.

On a ainsi obtenu un composant normalement passant et commandé à l'ouverture. Toutefois, si la tension de commande sur la borne G est interrompue, le composant redevient passant.

En outre, pour constituer un thyristor dual bidirectionnel en courant, une diode D est connectée par son anode à la borne K et par sa cathode à la borne A. Cette diode n'a pas été représentée par souci de simplicité ni dans cette figure, ni dans les suivantes.

La figure 3B reproduit le circuit de la figure 3A. Le thyristor Th a été représenté de façon classique par ses deux transistors équivalents T1 et T2. Ce schéma équivalent pourrait être utilisé chaque fois que l'on a représenté un thyristor.

La figure 4 représente une modification du circuit de la figure 3A permettant de commander le composant par impulsion, c'est-à-dire que le composant est mis à l'état de blocage par une impulsion de commande puis reste bloqué alors que la tension à ses bornes reste positive, même si aucun signal de commande n'est maintenu.

On retrouve dans le schéma de la figure 4 les éléments Th, M_{D}1 et M_{E}2 décrits en relation avec la figure 3A. En outre, un transistor MOS à enrichissement M_{E}3 est connecté en parallèle, par ses bornes principales, sur le transistor M_{E}2. La grille du transistor M_{E}3 est connectée à un noeud C. Le noeud C est connecté à la cathode d'une diode Zener Z dont l'anode est reliée à la borne K. Le noeud C est également relié à la borne GA par l'intermédiaire d'un transistor MOS à canal N à déplétion M_{D}4 dont la grille est reliée à la borne K. Chacun des transistors M_{E}3 et M_{D}4 a sa source reliée à son substrat.

La mise en conduction du thyristor Th est assurée comme précédemment par le transistor MOS à déplétion M_{D}1. Une fois qu'un ordre de blocage est appliqué sur la borne de grille G du transistor M_{E}2, la tension sur la borne A et donc sur la borne GA croît par rapport à la tension sur la borne K. La tension sur la borne GA se retrouve par l'intermédiaire du transistor M_{D}4 sur le noeud C, c'est-à-dire sur la grille du transistor M_{E}3. Ce transistor M_{E}3 devient passant et maintient l'état de court-circuit entre cathode et gâchette de cathode du thyristor Th même si la commande sur la gâchette G est interrompue. La diode Zener Z sert à limiter la tension de grille du transistor M_{E}3.

Ainsi, le thyristor dual de la figure 4 peut effectivement être commandé au blocage par une impulsion sur la borne G et reste bloqué tant que la tension sur la borne C reste supérieure à la tension de seuil du transistor M_{E}3, c'est-à-dire sensiblement tant que la tension V_{AK} est supérieure à la tension de seuil du transistor M_{E}3.

Le circuit de la figure 4 présente un inconvénient en ce que, à l'état de blocage, il demeure un courant de fuite à travers le transistor à déplétion M_{D}1. Pour limiter ce courant de fuite, il faudrait augmenter la résistance à l'état passant de ce transistor M_{D}1, ce qui présenterait des inconvénients quant à la sensibilité de la mise en conduction initiale du thyristor dual.

Pour pallier cet inconvénient, selon une variante de la présente invention, il est proposé de disposer en série avec le transistor M_{D}1 un interrupteur qui est ouvert quand le dispositif passe à l'état de blocage. La figure 5 représente un exemple de réalisation d'une telle structure éliminant ce courant de fuite à l'état de blocage.

Le circuit de la figure 5 est identique à celui de la figure 4 avec ajout d'un transistor MOS à canal P à déplétion et à substrat flottant M_{D}5 en série avec le transistor M_{D}1 entre les bornes GA et K. La grille du transistor M_{D}5 est connectée au noeud C.

Ainsi, quand la tension anode-cathode devient positive à partir d'une valeur nulle, les transistors MOS à déplétion M_{D}1 et M_{D}5 sont tous les deux conducteurs et assurent l'amorçage du thyristor Th. Quand le dispositif est bloqué conformément à ce qui a été exposé en relation avec la figure 4, l'augmentation de potentiel sur le noeud C bloque le transistor M_{D}5. On obtient ainsi une annulation sensiblement complète du courant de fuite.

Dans ce qui précède, on n'a pas décrit la fonction d'auto-blocage quand le courant dans le thyristor dual dépasse un seuil déterminé. En effet, cette caractéristique est rarement utile dans des applications pratiques. Elle existe toutefois dans les modes de réalisation des figures 4 et 5 et survient quand le courant dans le thyristor Th induit dans celui-ci une chute de tension supérieure à la somme de la tension de seuil du transistor M_{E}3 et de la tension de saturation du transistor M_{D}4.

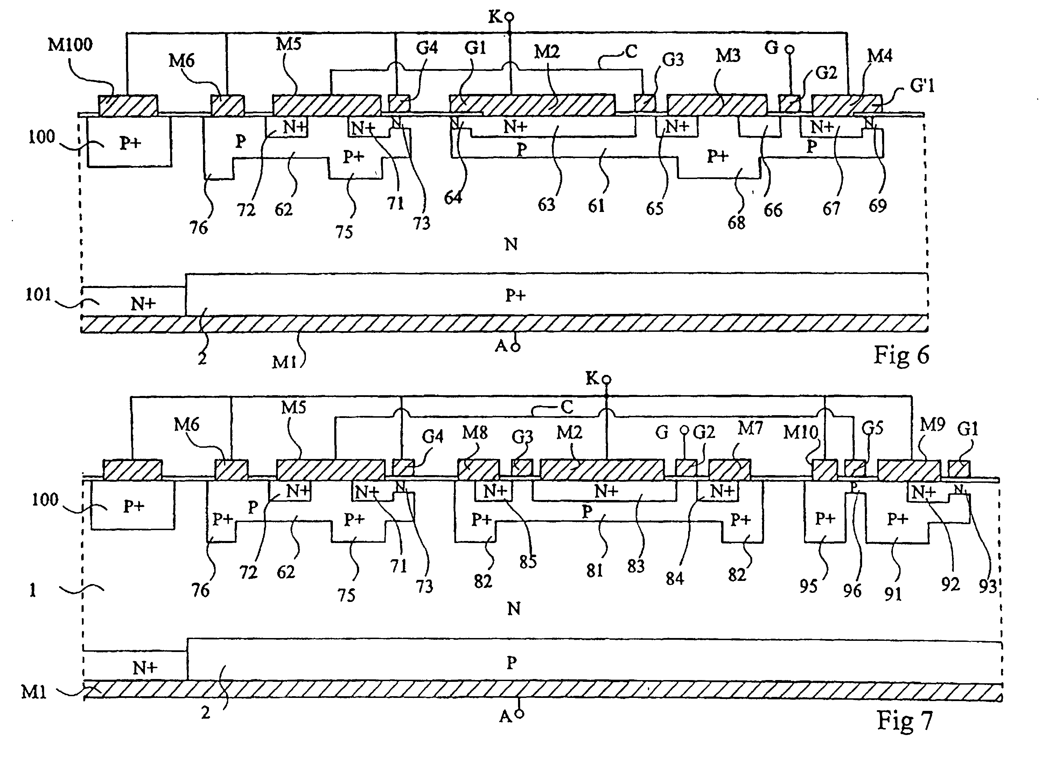

Les figures 6 et 7 représentent très schématiquement des vues en coupe simplifiées de structures semiconductrices monolithiques mettant en oeuvre respectivement les circuits des figures 4 et 5.

Comme cela est usuel dans le domaine de la représentation des composants semiconducteurs, les diverses couches et régions de ces structures ne sont pas tracées à l'échelle mais leurs dimensions ont été arbitrairement modifiées pour améliorer la lisibilité et faciliter le tracé des figures.

Les structures représentées sont formées à partir d'un substrat 1 de type N faiblement dopé dont la face arrière est revêtue d'une couche 2 de type P⁺ uniformément revêtue d'une métallisation d'anode M1. On notera que, si l'on veut munir la structure d'une diode anti-parallèle, on pourra prévoir d'interrompre partiellement la région 2 de type P⁺ et diffuser à la place une région de type N⁺ en regard d'une région de type P⁺ formée du côté de la face supérieure, comme cela est indiqué dans la partie gauche des figures 6 et 7.

En figure 6, du côté de la face supérieure, on trouve quatre types de régions :
- des régions fortement dopées de type P (P⁺),
- des régions plus faiblement dopées de type P (P),
- des régions fortement dopées de type N (N⁺), et
- des régions plus faiblement dopées de type N correspondant aux canaux préformés de transistors MOS à canal N à déplétion.

En outre, en figure 7, on trouve une région 96 faiblement dopée de type P destinée à constituer le canal préformé du transistor MOS à canal P à déplétion et à substrat flottant M_{D}5.

En figure 6, du côté de la face supérieure du substrat, sont formés deux caissons 61 et 62 de type P.

Dans le caisson 61, une région 63 de type N⁺ constitue la région de cathode du thyristor Th. Une partie 64 du caisson 61, intermédiaire entre la région 63 et une partie supérieure du substrat 1, est remplacée par une région de type N faiblement dopée constituant un canal préformé pour le transistor M_{D}1. Cette région 64 est revêtue d'une métallisation de grille isolée G1. La métallisation G1 peut être constituée d'un prolongement d'une métallisation M2 revêtant la région 63 et constituant la métallisation de cathode du thyristor.

Dans le caisson 61, entre la région 63 et une autre région 65 de type N⁺ est formé un transistor MOS à canal N à enrichissement dont la région de canal est revêtue d'une métallisation de grille isolée G3. Ce transistor correspond au transistor M_{E}3 de la figure 4.

Dans le caisson 61, est également formé le transistor MOS à enrichissement M_{E}2 entre des régions 66 et 67 de type N⁺. La grille de ce transistor est désignée par la référence G2. Une métallisation M3 est en contact avec les surfaces supérieures des régions 65 et 66 et avec une zone surdopée P⁺ 68 du caisson 61. Une métallisation M4 recouvre la région 67. Cette métallisation M4 est reliée à la borne K et, à titre d'exemple d'une variante de l'invention, on a représenté un prolongement de cette métallisation M4 constituant une grille G'1 d'une autre portion du transistor à déplétion M_{D}1 au-dessus d'une zone de type N faiblement dopée 69 s'étendant entre la région 67 et une portion de surface supérieure du substrat 1.

Dans le caisson 62 sont formées des régions 71 et 72 de type N⁺. Une région de canal préformé 73 s'étend à la surface supérieure du composant entre la région 71 et une partie supérieure du substrat 1. Ce canal est revêtu d'une grille isolée G4. Une métallisation M5 recouvre la partie supérieure de la région 71, une surface apparente d'une région surdopée 75 du caisson 62 et la surface supérieure de la région 72. Une métallisation M6 est en contact avec une partie apparente surdopée 76 du caisson 62. La métallisation M5 est reliée à la métallisation G3 qui correspond à la borne C. La métallisation M6 est reliée à la borne de cathode K.

Pour bien comprendre comment la structure de la figure 6 correspond au circuit de la figure 4, on notera que le caisson 61 correspond à la gâchette de cathode GK du thyristor Th et que le substrat 1 correspond à sa gâchette d'anode GA. Ainsi :
- le thyristor Th comprend, entre les métallisations M1 et M2, les régions 2-1-61-63 ;
- le transistor M_{D}1 a une source 63 (67) reliée à la borne K par la métallisation M2 (M4), une grille G1 (G'1) reliée à la cathode K, et un drain qui correspond au substrat 1 ; le substrat de ce transistor M_{D}1 correspond au caisson 61, c'est-à-dire à la borne GK ;
- le transistor M_{E}2 a un drain 66 qui est relié par la métallisation M3 à la région 61, qui correspond au substrat de ce transistor M_{E}2 et à la borne GK ; sa grille G2 est connectée à une borne de commande G ; et sa source 67 est reliée par la métallisation M4 à la borne K ;
- le transistor M_{E}3 a pour source la région 63 confondue avec la région de cathode du thyristor, et pour drain la région 65 reliée par la métallisation M3 à son substrat qui est aussi la zone 68 correspondant à une portion de la couche de gâchette de cathode 61 ;
- le transistor M_{D}4 a pour source la région 71 reliée par la métallisation M5 au substrat de ce transistor et au noeud C et a pour drain le substrat 1 ;
- la diode Zener Z correspond à la jonction entre le caisson 62 et la région 72. Sa cathode correspond à la région 72 et est reliée par la métallisation M5 au noeud C. Son anode correspond à une région surdopée 76 du caisson 62 et est reliée par la métallisation M6 à la borne K.

En outre, comme on l'a indiqué précédemment, une diode en anti-parallèle est formée entre une région P⁺ 100 revêtue d'une métallisation M100 du côté de la face supérieure et une région N⁺ 101 revêtue de la métallisation M1 du côté de la face inférieure.

On notera que cette structure est susceptible de très nombreuses variantes de réalisation, l'essentiel étant que les fonctions décrites ci-dessus d'un thyristor, de quatre transistors MOS et d'une diode Zener soient réalisées.

D'ailleurs, dans la description ci-dessous d'un exemple d'intégration monolithique du circuit de la figure 5, des variantes de réalisation ont été apportées à divers éléments. De plus, les métallisations représentées schématiquement comme connectées par des fils à la borne K ou au noeud C pourront être constituées d'une seule et même métallisation si les considérations topologiques le permettent.

La figure 7 représente un mode de réalisation du circuit de la figure 5.

Dans la partie gauche de la figure 7, on retrouve des caissons et régions 62, 71, 72, 73, 75, 76 identiques à ce qui est représenté en figure 6 et revêtues de métallisations M6, M5 et G4. Cet ensemble constitue comme en figure 6 une réalisation du transistor M_{D}4 et de la diode Z.

Dans la partie centrale de la figure 7 est représenté un caisson 81 de type P dont la périphérie est constituée d'une région plus fortement dopée 82 de type P⁺. Dans ce caisson, une région principale 83 de type N⁺ constitue la cathode du thyristor et est revêtue d'une métallisation M2. Deux caissons 84 et 85 constituent les drains des transistors M_{E}2 et M_{E}3 et sont séparés de la région 83 par des portions du caisson 81 revêtues de métallisations de grille isolées G2 et G3. La métallisation G2 est reliée à une borne de commande G. La métallisation G3 est reliée au noeud C. La région 84 et une portion de la région surdopée 82 du caisson sont revêtues d'une métallisation M7 correspondant à la liaison source-substrat du transistor M_{E}2 et à une liaison entre cette source et le caisson 81 qui correspond à la gâchette de cathode du thyristor. De même, la région 85 est reliée à une portion de la région 82 par une métallisation M8.

Dans la partie droite de la figure 7 est représenté un caisson 91 de type P⁺ dans lequel est formée une région 92 de type N⁺. Une région 93 de canal préformé de type N faiblement dopé s'étend entre la région 92 et une partie supérieure du substrat 1. Cette région de canal préformé est revêtue d'une grille isolée G1 connectée à la cathode K. Une métallisation M9 relie les surfaces apparentes des régions 91 et 92. En outre, au voisinage immédiat de la région de type P fortement dopée 91 est formée une région de type P fortement dopée 95. Les régions 91 et 95 sont séparées par une région de canal préformé 96 faiblement dopée de type P et la région 95 est revêtue d'une métallisation M10 reliée à la cathode K.

On retrouve donc bien dans cette structure :
- un thyristor Th constitué des régions 2-1-81-83 entre les métallisations M1 et M2 (les bornes A et K),
- un transistor MOS M_{D}1 dont la source correspond à la région 92, le drain au substrat 1, et la grille à la métallisation G1,
- un transistor MOS M_{E}2 dont la source correspond à la région 83, le drain à la région 84 et la grille à la métallisation G2,
- un transistor MOS M_{E}3 dont la source correspond à la région 83, le drain à la région 85, la grille à la métallisation G3 et le substrat à la région 81,
- un transistor MOS M_{E}4 identique à celui de la figure 6,
- une diode Zener Z identique à celle de la figure 6,
- un transistor MOS à canal P à déplétion et à substrat flottant M_{D}5 dont la source correspond à la région 91, le drain à la région 95, la grille à la métallisation G5, et le substrat au substrat 1.

Les perfectionnements habituellement apportés aux thyristors, courts-circuits d'émetteur, pourront être utilisés. Des régions d'arrêt de canal et des régions d'isolement entre composants pourront également être prévues.

## Revendications

1. Composant constituant un thyristor dual, normalement passant et bloquable par une impulsion de tension sur l'électrode de commande, comprenant :
- un thyristor (Th),
- un moyen résistif constitué d'un premier transistor MOS à déplétion (M_{D}1) dont la grille est reliée à la source, le substrat de ce transistor étant relié à la borne de gâchette de cathode, ledit premier transistor étant connecté entre la gâchette d'anode (GA) et la cathode (K) du thyristor, et
- un moyen interrupteur à conduction commandée constitué d'un deuxième transistor MOS à enrichissement (M_{E}2) dont la grille est connectée à une borne de commande (G) et dont le substrat est connecté à la borne de gâchette de cathode (GK), ledit deuxième transistor étant connecté entre la gâchette de cathode (GK) et la cathode (K) du thyristor.

2. Composant selon la revendication 1, à commande par impulsion, **caractérisé en ce qu'**il comprend en outre des moyens de maintien de la conduction entre la gâchette de cathode et la cathode dès que cette conduction a été amorcée par ledit moyen interrupteur.

3. Composant selon la revendication 2, **caractérisé en ce que** lesdits moyens de maintien comprennent :
un troisième transistor MOS à enrichissement (M_{E}3), dont le substrat est connecté à la borne de gâchette de cathode (GK), en parallèle sur le deuxième transistor MOS à enrichissement (M_{E}2) ;
une diode Zener (Z) connectée entre la cathode du thyristor et un noeud (C) lié à la grille du troisième transistor (M_{E}3) et
un quatrième transistor MOS à déplétion (M_{D}4) connecté entre ledit noeud (C) et la gâchette d'anode du thyristor, la grille du quatrième transistor étant connectée à la cathode (K) et son substrat audit noeud.

4. Composant selon l'une quelconque des revendications 1 à 3, à faible courant de fuite, **caractérisé en ce qu'**il comprend, en série avec le premier transistor MOS à déplétion (M_{D}1), un deuxième moyen interrupteur, normalement passant et bloqué après qu'un ordre de commande a été appliqué au deuxième transistor (M_{E}2).

5. Composant selon la revendication 4, **caractérisé en ce que** le deuxième moyen interrupteur est un transistor MOS à déplétion à canal P et à substrat flottant (M_{D}5) dont la grille est connectée audit noeud (C).

6. Composant monolithique selon la revendication 3,
**caractérisé en ce que** :
le thyristor (Th) est réalisé sous forme verticale dans un substrat de silicium (1) d'un premier type de conductivité ;
le premier transistor MOS à déplétion (M_{D}1) est réalisé entre la région de cathode (63) du thyristor et le substrat ;
chacun des deuxième et troisième transistors MOS à enrichissement (M_{E}2, M_{E}3) est formé entre deux régions (63, 65 ; 66, 67) du premier type de conductivité formées dans un premier caisson de gâchette de cathode (61) du thyristor, l'une de ces deux régions (63 ; 67) correspondant à la région de cathode du thyristor ;
le quatrième transistor MOS à déplétion (M_{D}4) est formé entre une région du premier type de conductivité (71), elle-même formée dans un deuxième caisson (62) du deuxième type de conductivité (67) disjoint du premier caisson, et le substrat ; et
la diode Zener (Z) est formée dans ledit deuxième caisson (62).

7. Composant monolithique selon la revendication 6, formé à partir d'un substrat (1) du premier type de conductivité dont la face arrière est revêtue d'une couche (2) du deuxième type de conductivité revêtue d'une première métallisation (M1), **caractérisé en ce qu'**il comprend du côté de sa face avant :
- un premier caisson (61) du deuxième type de conductivité contenant des première (63), deuxième (65), troisième (66) et quatrième (67) régions du premier type de conductivité, les première et deuxième régions étant séparées par une portion du premier caisson revêtue d'une première métallisation de grille isolée (G3), les troisième et quatrième régions étant séparées par une portion du premier caisson revêtue d'une deuxième métallisation de grille isolée (G2), une portion au moins du premier caisson séparant la première (63) et/ou la quatrième (67) région du substrat (1) comportant en face supérieure une première région de canal préformé (64 ; 69) revêtue d'une troisième métallisation de grille isolée (G1 ; G'1), une deuxième métallisation (M2) revêtant la première région (63), une troisième métallisation (M3) revêtant les deuxième (65) et troisième (66) régions et une portion de la surface supérieure du premier caisson, une quatrième métallisation (M4) revêtant la quatrième région ; et
- un deuxième caisson (62) du deuxième type de conductivité comprenant des cinquième (71) et sixième (72) régions du premier type de conductivité, la cinquième région (71) étant séparée du substrat par une deuxième région de canal préformé (73) revêtue d'une quatrième métallisation de grille isolée (G4), la sixième région (72) formant avec le deuxième caisson une jonction Zener, une cinquième métallisation (M5) revêtant les cinquième et sixième régions et les reliant au deuxième caisson (62), une sixième métallisation (M6) étant en contact avec une portion du deuxième caisson (62) voisine de la sixième région (72) ;
la deuxième métallisation de grille isolée (G2) étant destinée à être connectée à une borne de commande (G), les deuxième (M2), quatrième (M4) et sixième (M6) métallisations ainsi que les troisième (G1) et quatrième (G4) métallisations de grille isolée étant destinées à être connectées à une borne de cathode (K), la cinquième métallisation (M5) étant reliée à la première métallisation de grille isolée (G3) (noeud C).

8. Composant monolithique selon la revendication 5, **caractérisé en ce que** :
le thyristor (Th) est réalisé sous forme verticale dans un substrat de silicium (1) d'un premier type de conductivité ;
le premier transistor MOS à déplétion (M_{D}1) est formé dans un troisième caisson (91) disjoint du premier caisson de gâchette de cathode (81) du thyristor, entre une région (92) formée dans ce troisième caisson et le substrat ;
chacun des deuxième et troisième transistors MOS à enrichissement (M_{E}2, M_{E}3) est formé entre une région (84 ; 85) du premier type de conductivité, formée dans le caisson de gâchette de cathode (81) du thyristor, et la région de cathode (83) du thyristor ;
le quatrième transistor MOS à déplétion (M_{D}4) est formé entre une région du premier type de conductivité (71), elle-même formée dans un deuxième caisson (62) du deuxième type de conductivité disjoint du caisson de gâchette du thyristor, et le substrat ;
la diode Zener (Z) est formée dans ledit deuxième caisson (62) ; et
le cinquième transistor MOS à canal P à déplétion (M_{D}5) est formé entre le deuxième caisson (91) et une région supplémentaire (95) du deuxième type de conductivité.

9. Composant monolithique selon la revendication 8, formé à partir d'un substrat (1) du premier type de conductivité dont la face arrière est revêtue d'une couche (2) du deuxième type de conductivité revêtue d'une première métallisation (M1), **caractérisé en ce qu'**il comprend du côté de sa face avant :
- un premier caisson (81) du deuxième type de conductivité contenant des première (83), deuxième (84) et troisième (85) régions du premier type de conductivité, les première et deuxième régions étant séparées par une portion du premier caisson revêtue d'une première métallisation de grille isolée (G2), les première et troisième régions étant séparées par une portion du premier caisson revêtue d'une deuxième métallisation de grille isolée (G3), la première région (83) étant revêtue d'une deuxième métallisation (M2), la deuxième région (84) étant revêtue d'une troisième métallisation (M7) s'étendant sur une portion du premier caisson, la troisième région (85) étant revêtue d'une quatrième métallisation (M8) s'étendant sur une portion du premier caisson ;
- un deuxième caisson (62) du deuxième type de conductivité comprenant des quatrième (71) et cinquième (72) régions du premier type de conductivité, la quatrième région (71) étant séparée du substrat par une première région de canal préformé (73) revêtue d'une troisième métallisation de grille isolée (G4), la cinquième région (72) formant avec le deuxième caisson une jonction Zener, une cinquième métallisation (M5) revêtant les quatrième (71) et cinquième (72) régions et les reliant au deuxième caisson (62), une sixième métallisation (M6) étant en contact avec une portion du deuxième caisson (62) voisine de la cinquième région (72) ; et
- un troisième caisson (91) du deuxième type de conductivité contenant une sixième région (92) du premier type de conductivité, une portion au moins du caisson séparant la sixième région (92) du substrat (1) comportant en face supérieure une deuxième région de canal préformé (93) revêtue d'une quatrième métallisation de grille isolée (G1), le troisième caisson (91) étant séparé d'une région (95) du deuxième type de conductivité par une région du deuxième type de conductivité faiblement dopée (96) revêtue d'une cinquième métallisation de grille isolée (G5), la sixième région et une partie de la surface supérieure du troisième caisson étant revêtues d'une septième métallisation (M9), la surface supérieure de ladite région du deuxième type de conductivité faiblement dopée (96) étant revêtue d'une huitième métallisation (M10) ;
la première métallisation de grille isolée (G2) étant destinée à être connectée à une borne de commande (G), les deuxième (M2), sixième (M6) et huitième (M10) métallisations ainsi que les troisième (G4) et quatrième (G1) métallisations de grille isolée étant destinées à être connectées à une borne de cathode (K), la cinquième métallisation (M5) étant reliée aux deuxième (G3) et cinquième (G5) métallisations de grille isolée (noeud C).

10. Composant monolithique selon la revendication 7 ou 9, **caractérisé en ce que** chacun des caissons comprend des zones plus fortement dopées au moins aux emplacements où une métallisation est en contact avec une portion de leur surface supérieure.

## Claims

1. A component forming a dual thyristor, which is normally on and which can be turned off by a voltage pulse on the control electrode, including:
- a thyristor (Th),
- a resistive means formed of a first depletion MOS transistor (M_{D}1), the gate of which is connected to the source, the substrate of this transistor being connected to the cathode gate terminal, said first transistor being connected between the anode gate (GA) and the thyristor cathode (K), and
- a controlled switching means formed of a second enhancement MOS transistor (M_{E}2), the gate of which is connected to a control terminal (G) and the substrate of which is connected to the cathode gate (GK) terminal, said second transistor being connected between the cathode gate (GK) and the thyristor cathode (K).

2. The component of claim 1, pulse-controlled, **characterized in that** it further includes means for maintaining the conduction between the cathode gate and the cathode as soon as this conduction has been triggered by the switching means.

3. The component of claim 2, **characterized in that** the maintaining means include:
a third enhancement MOS transistor (M_{E}3), the substrate of which is connected to the cathode gate terminal (GK), in parallel with the second enhancement MOS transistor (M_{E}2);
a zener diode (Z) connected between the cathode of the thyristor and a node (C) connected to the gate of the third transistor (M_{E}3); and
a fourth depletion MOS transistor (M_{D}4) connected between said node (C) and the anode gate of the thyristor, the gate of the fourth transistor being connected to the cathode (K) and its substrate being connected to said node.

4. The component of any of claims 1 to 3, of low leakage current, **characterized in that** it includes, in series with the first depletion MOS transistor (M_{D}1), a second switching means, normally on and turned off after a control order has been applied to the second transistor (M_{E}2).

5. The component of claim 4, **characterized in that** the second switching means is a floating substrate P-channel depletion MOS transistor (M_{D}5), the gate of which is connected to said node (C) .

6. The monolithic component of claim 3, **characterized in that**:
the thyristor (Th) is implemented in vertical form in a silicon substrate (1) of a first conductivity type;
the first depletion MOS transistor (M_{D}1) is implemented between the cathode region (63) of the thyristor and the substrate;
each of the second and third enhancement MOS transistors (M_{E}2, M_{E}3) is formed between two regions (63, 65; 66, 67) of the first conductivity type formed in a first cathode gate well (61) of the thyristor, one of these two regions (63; 67) corresponding to the cathode region of the thyristor;
the fourth depletion MOS transistor (M_{D}4) is formed between a region of the first conductivity type (71), itself formed in a second well (62) of the second conductivity type (67) separated from the gate well of the thyristor, and the substrate; and
the zener diode (Z) is formed in the second well (62).

7. The monolithic component-of claim 6, formed from a substrate (1) of the first conductivity type, the rear surface of which is coated with a layer (2) of the second conductivity type coated with a first metallization (M1), **characterized in that** it includes, on its front surface side:
- a first well (61) of the second conductivity type containing first (63), second (65), third (66), and fourth (67) regions of the first conductivity type, the first and second regions being separated by a portion of the first well coated with a first insulated gate metallization (G3), the third and fourth regions being separated by a portion of the first well coated with a second insulated gate metallization (G2), a portion at least of the first well separating the first (63) and/or the fourth (67) region from the substrate (1) including at its upper surface a first preformed channel region (64; 69) coated with a third insulated gate metallization (G1; G'1), a second metallization (M2) coating the first region (63), a third metallization (M3) coating the second (65) and third (66) regions and a portion of the upper surface of the first well, a fourth metallization (M4) coating the fourth region; and
a second well (62) of the second conductivity type including fifth (71) and sixth (72) regions of the first conductivity type, the fifth region (71) being separated from the substrate by a second preformed channel region (73) coated with a fourth insulated gate metallization (G4), the sixth region (72) forming with the second well a zener junction, a fifth metallization (M5) coating the fifth and sixth regions and connecting them to the second well, a sixth metallization being in contact with a portion of the second well (62), a sixth metallization (M6) being in contact with a portion of the second well (62) neighboring the sixth region (72);
the second insulated gate metallization (G2) being meant to be connected to a control terminal (G), the second (M2), fourth (M4), and sixth (M6) metallizations as well as the third (G1) and fourth (G4) insulated gate metallizations being meant to be connected to a cathode terminal (K), the fifth metallization (M5) being connected to the first insulated gate metallization (G3) (node C).

8. The monolithic component of claim 5, **characterized in that**:
the thyristor (Th) is implemented in vertical form in a silicon substrate (1) of a first conductivity type;
the first depletion MOS transistor (M_{D}1) is formed in a third well (91) separated from the first cathode gate well (81) of the thyristor, between a region (92) formed in this third well and the substrate;
each of the second and third enhancement MOS transistors (M_{E}2, M_{E}3) is formed between a region (84; 85) of the first conductivity type, formed in the cathode gate well (81) of the thyristor, and the cathode region (83) of the thyristor;
the fourth depletion MOS transistor (M_{D}4) is formed between a region of the first conductivity type (71), itself formed in a second well (62) of the second conductivity type separated from the gate well of the thyristor, and the substrate;
the zener diode (Z) is formed in the second well (62); and
the fifth P-channel depletion MOS transistor (M_{D}5) is formed between the second well (91) and an additional region (95) of the second conductivity type.

9. The monolithic component of claim 8, formed from a substrate (1) of the first conductivity type, the rear surface of which is coated with a layer (2) of the second conductivity type coated with a first metallization (M1), **characterized in that** it includes, on its front surface side:
- a first well (81) of the second conductivity type containing first (83), second (84), and third regions (85) of the first conductivity type, the first and second regions being separated by a portion of the first well coated with a first insulated gate metallization (G2), the first and third regions being separated by a portion of the first well coated with a second insulated gate metallization (G3), the first region (83) being coated with a second metallization (M2), the second region (84) being coated with a third metallization (M7) extending over a portion of the first well, the third region (85) being coated with a fourth metallization (M8) extending over a portion of the first well;
- a second well (62) of the second conductivity type including fourth (71) and fifth (72) regions of the first conductivity type, the fourth region (71) being separated from the substrate by a first preformed channel region (73) coated with a third insulated gate metallization (G4), the fifth region (72) forming with the second well a zener junction, a fifth metallization (M5) coating the fourth (71) and fifth (72) regions and connecting them to the second well (62), a sixth metallization (M6) being in contact with a portion of the second well (62) neighboring the fifth region (72); and
- a third well (91) of the second conductivity type containing a sixth region (92) of the first conductivity type, a portion at least of the well separating the sixth region (92) from the substrate (1) including at its upper surface a second preformed channel region (93) coated with a fourth insulated gate metallization (G1), the third well (91) being separated from a region (95) of the second conductivity type by a lightly-doped region (96) of the second conductivity type coated with a fifth insulated gate metallization (G5), the sixth region and a portion of the upper surface of the third well being coated with a seventh metallization (M9), the upper surface of the lightly-doped region (96) of the second conductivity type being coated with an eighth metallization (M10);
the first insulated gate metallization (G2) being meant to be connected to a control terminal (G), the second (M2), sixth (M6), and eighth (M10) metallizations as well as the third (G4) and fourth (G1) insulated gate metallizations being meant to be connected to a cathode terminal (K), the fifth metallization (M5) being connected to the second (G3) and fifth (G5) insulated gate metallizations (node C).

10. The monolithic component of claim 7 or 9, **characterized in that** each of the wells includes more heavily-doped areas at least at the locations where a metallization is in contact with a portion of their upper surface.

## Patentansprüche

1. Komponente, die einen Dualthyristor bildet, der normalerweise leitet und durch einen Spannungsimpuls auf die Steuerelektrode sperrbar ist, mit:
- einem Thyristor (Th),
- einer Widerstandseinrichtung, die durch einen ersten MOS-Transistor (N_{D}1) vom Verarmungstyp gebildet ist, dessen Gate mit der Source verbunden ist,
wobei das Substrat dieses Transistors mit dem Anschluss der Gatekathode verbunden ist und dieser erste Transitor zwischen die Gate-Anode (GA) und die Kathode (K) des Thyristors geschaltet ist.
- einer gesteuerten Schalteinrichtung, die durch einen zweiten MOS-Transistor (M_{E}2) vom Anreicherungstyp gebildet ist, dessen Gate mit einem Steueranschluss (G) verbunden ist und dessen Substrat mit dem Anschluss der Gatekathode (GK) verbunden ist,
wobei dieser zweite Transistor zwischen die Gatekathode (GK) und die Kathode (K) des Thyristors geschaltet ist.

2. Komponente nach Anspruch 1 mit Impulssteuerung, **dadurch gekennzeichnet, dass** sie ferner Einrichtungen aufweist zum Halten des leitenden Zustandes zwischen der Gatekathode und der Kathode, sobald dieser leitende Zustand durch die besagte Schalteinrichtung aktiviert worden ist.

3. Komponente nach Anspruch 2, **dadurch gekennzeichnet, dass** die Halteeinrichtungen aufweisen:
einen dritten MOS-Transistor (M_{E}3) vom Anreicherungstyp, dessen Substrat mit dem Anschluss der Gatekathode (GK) verbunden ist und der parallel zu dem zweiten MOS-Transistor (M_{E}2) vom Anreicherungstyp gelegen ist;
eine Zener-Diode Z, die zwischen die Kathode des Thyristors und einen Knoten (C) an dem Gate des dritten Transistors (M_{E}3) geschaltet ist; und
Einen vierten MOS-Transistor (M_{D}4) vom Verarmungstyp, der zwischen diesen Knoten (C) und die Gate-Anode des Thyristors geschaltet ist,
wobei das Gate des vierten Transistors mit der Kathode (K) und sein Substrat mit dem Knoten verbunden sind.

4. Komponente nach einem der Ansprüche 1 bis 3 mit geringem Leckstrom, **dadurch gekennzeichnet, dass** sie in Serie mit dem ersten MOS-Transistor (M_{D}1) vom Verarmungstyp eine zweite Schalteinrichtung aufweist, die normalerweise leitend ist und gesperrt wird, nachdem ein Steuerbefehl an den zweiten Transistor (M_{E}2) angelegt worden ist.

5. Komponente nach Anspruch 4, **dadurch gekennzeichnet, dass** die zweite Schalteinrichtung ein MOS-Transistor (M_{D}5) vom Verarmungstyp und mit einem P-Kanal und einem schwebenden Substrat ist, dessen Gate mit dem Knoten (C) verbunden ist.

6. Festkörperkomponente nach Anspruch 3, **dadurch gekennzeichnet, dass**:
der Thyristor (Th) in vertikaler Form in einem Siliziumsubstrat (1) eines ersten Leitungstypes ausgebildet ist;
der erste MOS-Transistor (M_{D}1) vom Verarmungstyp zwischen dem Bereich der Kathode (63) des Thyristors und dem Substrat ausgebildet ist;
der zweite und der dritte MOS-Transistor (M_{E}2, M_{E}3) vom Anreicherungstyp jeweils zwischen zwei Bereichen (63, 65 ; 66 , 67) des ersten Leitungstypes ausgebildet sind, die in einem ersten Feld der Gatekathode (61) des Thyristors ausgebildet sind, wobei einer dieser zwei Bereiche (63; 67) dem Bereich der Kathode des Thyristors entspricht;
der vierte MOS-Transistor (M_{D}4) vom Verarmungstyp zwischen einem Bereich (71) vom ersten Leitungstyp und dem Substrat ausgebildet ist, wobei er selbst in einem zweiten Feld (62) des zweiten Leitungstypes (67) ausgebildet ist, welches vom ersten Feld getrennt ist; und
die Zener-Diode (Z) in diesem zweiten Feld (62) ausgebildet ist.

7. Festkörperkomponente nach Anspruch 6, die ausgehend von einem Substrat (1) des ersten Leitungstypes ausgebildet ist, dessen Rückseite mit einer Schicht (2) des zweiten Leitungstypes bedeckt ist, welche mit einer ersten Metallisierung (M1) bedeckt ist, **dadurch gekennzeichnet, dass** sie auf ihrer Oberseite aufweist:
- ein erstes Feld (61) des zweiten Leitungstypes, das einen ersten (63), zweiten (65), dritten (66) und vierten Bereich (67) vom ersten Leitungstyp enthält, wobei der erste und der zweite Bereich durch einen Teil des ersten Feldes getrennt sind, der mit einer ersten Metallisierung eines isolierten Gates (G3) bedeckt ist, der dritte und vierte Bereich durch einen Teil des ersten Feldes getrennt sind, der mit einer zweiten Metallisierung eines isolierten Gates (G2) bedeckt ist, ein Teil zumindest des ersten Feldes den ersten (63) und/oder den vierten Bereich (67) von dem Substrates trennt, das auf der oberen Seite einen ersten vorgeformten Kanalbereich (64; 69) aufweist, der mit einer dritten Metallisierung eines isolierten Gates (G1 ; G'1) bedeckt ist, eine zweite Metallisierung (M2) den ersten Bereich (63) bedeckt, eine dritte Metallisierung (M3) den zweiten (65) und dritten Bereich (66) und einen Teil der oberen Fläche des ersten Feldes bedeckt, eine vierte Metallisierung (M4) den vierten Bereich bedeckt; und
- ein zweites Feld (62) vom zweiten Leitungstyp, das einen fünften (71) und einen sechsten Bereich (72) des ersten Leitungstypes aufweist, wobei der fünfte Bereich (71) von dem Substrat durch einen zweiten vorgeformten Kanalbereich (73) getrennt ist, der mit einer vierten Metallisierung eines isolierten Gates (G4) bedeckt ist, der sechste Bereich (72) mit dem zweiten Feld einen Zener-Übergang bildet, eine fünfte Metallisierung (M5) den fünften und den sechsten Bereich bedeckt und diese mit dem zweiten Feld (62) verbindet, eine sechste Metalliserung (M6) in Kontakt mit einem Teil des benachbart zu dem sechsten Bereich (72) gelegenen zweiten Feld (62) steht;
wobei die zweite Metallisierung eines isolierten Gates (G2) dazu bestimmt ist, mit einem Steueranschluss (G) verbunden zu werden, die zweite (M2), vierte (M4) und sechste Metallisierung (M6) ebenso wie die dritte (G1) und vierte Metallisierung (G4) eines isolierten Gates dazu bestimmt sind, mit einem Kathodenanschluss (K) verbunden zu werden, wobei die fünfte Metallisierung (M5) mit der ersten Metallisierung eines isolierten Gates (G3) verbunden ist (Knoten C).

8. Festkörperkomponente nach Anspruch 5, **dadurch gekennzeichnet, dass**:
der Thyristor (TH) in vertikaler Form in einem Siliziumsubstrat (1) eines ersten Leitungstypes ausgebildet ist;
der erste MOS-Transistor (N_{D}1) vom Verarmungstyp in einem dritten Feld (91), das getrennt von derm ersten Feld der Gatekathode (81) des Thyristors ist, zwischen einem Bereich (92), der in diesem dritten Feld ausgebildet ist, und dem Substrat ausgebildet ist;
der zweite und der dritte MOS-Transistor (M_{E}2, M_{E}3) vom Anreicherungstyp jeweils zwischen einem Bereich (84 ; 85) vom ersten Leitungstyp, der in dem Feld der Gatekathode (81) des Thyristors ausgebildet ist, und dem Kathodenbereich (83) des Thyristors ausgebildet sind;
der vierte MOS-Transistor (M_{D}4) vom Verarmungstyp zwischen einem Bereich (71) des ersten Leitungstypes, welcher selbst in einem zweiten Feld (62) des zweiten Leitungstypes getrennt von dem Gatefeld des Transistors ausgebildet ist, und dem Substrat ausgebildet ist;
die Zener-Diode in dem zweiten Feld (62) ausgebildet ist; und dass
der fünfte MOS-Transistor (M_{D}5) vom Verarmungstyp mit einem P-Kanal zwischen dem zweiten Feld (91) und einem zusätzlichen Bereich (95) des zweiten Leitungstypes ausgebildet ist.

9. Festkörperkomponente nach Anspruch 8, die ausgehend von einem Substrat (1) des ersten Leitungstypes ausgebildet ist, dessen rückwärtige Fläche mit einer Schicht (2) des zweiten Leitungstypes und diese mit einer ersten Metallisierung (M1) bedeckt ist, **dadurch gekennzeichnet, dass** es auf seiner oberen Fläche aufweist:
- ein erstes Feld (81) des zweiten Leitungstypes, das einen ersten (83), zweiten (84) und dritten Bereich (85) vom ersten Leitungstyp enthält, wobei der erste und der zweite Bereich durch einen mit einer ersten Metallisierung eines isolierten Gates (G2) bedeckten Teil des ersten Feldes getrennt sind, der erste und der dritte Bereich durch einen mit einer zweiten Metallisierung eines isolierten Gates (G3) bedeckten Teil des ersten Feldes getrennt sind, wobei der erste Bereich (83) mit einer zweiten Metallisierung (M2) bedeckt ist, der zweite Bereich (84) mit einer dritten Metallisierung (M7) bedeckt ist, die sich über einen Teil des ersten Feldes erstreckt, der dritte Bereich (85) mit einer vierten Metallisierung (M8) bedeckt ist, die sich über einen Teil des ersten Feldes erstreckt;
- ein zweites Feld (62) des zweiten Leitungstypes, das einen vierten (71) und fünften Bereich (72) des ersten Leitungstypes enthält, wobei der vierte Bereich (71) von dem Substrat durch einen ersten vorgeformten Kanalbereich (73) getrennt ist, der mit einer dritten Metallisierung eines isolierten Gates (G4) bedeckt ist, der fünfte Bereich (72) mit dem zweiten Feld einen Zener-Übergang bildet, eine fünfte Metallisierung (M5) den vierten (71) und fünften Bereich (72) bedeckt und diese mit dem zweiten Feld (62) verbindet, eine sechste Metallisierung (M6) in Kontakt mit einem Teil des zweiten Feldes (62) steht, der benachbart zu dem fünften Bereich (72) ist; und
- ein drittes Feld (91) vom zweiten Leitungstyp, das einen sechsten Bereich (92) vom ersten Leitungstyp enthält, wobei ein Teil zumindest des Feldes den sechsten Bereich (92) von dem Substrat trennt, das auf seiner Oberseite einen zweiten vorgeformten Kanalbereich (93) aufweist, der mit einer vierten Metallisierung eines isolierten Gates (G1) bedeckt ist, das dritte Feld (91) von einem Bereich (95) des zweiten Leitungstypes durch einen schwach dotierten Bereich (96) des zweiten Leitungstypes getrennt ist, der mit einer fünften Metallisierung eines isolierten Gates (G5) bedeckt ist, der sechste Bereich und ein Teil der oberen Oberfläche des dritten Feldes mit einer siebten Metallisierung (M9) bedeckt sind, wobei die obere Oberfläche des schwach dotierten Bereiches (96) des zweiten Leitungstypes mit einer achten Metallisierung (M10) bedeckt ist;
wobei die erste Metallisierung eines isolierten Gates (G2) dazu bestimmt ist, mit einem Steueranschluss (G) verbunden zu werden, die zweite (M2), sechste (M6) und achte Metallisierung (M10) ebenso wie die dritte (G4) und vierte (G1) Metallisierung eines isolierten Gates dazu bestimmt sind, mit einem Kathodenanschluss verbunden zu werden, wobei die fünfte Metallisierung (M5) mit der zweiten (G3) und fünften Metallisierung (G5) eines isolierten Gates verbunden ist (Knoten C).

10. Festkörperkomponente nach Anspruch 7 oder 9, **dadurch gekennzeichnet, dass** jedes der Felder stärker dotierte Zonen zumindest an Orten aufweist, wo eine Metallisierung in Kontakt mit einem Teil ihrer oberen Oberfläche ist.
